# EUROPEAN PATENT APPLICATION

(11) **EP 4 564 095 A1**
(43) Date of publication of application: **04.06.2025**
(21) Application number: 23213056.7
(22) Date of filing: 29.11.2023
(51) Int. Cl.: G03F 7/20

(54) **METHOD OF DETERMINING A CORRECTION FOR AN EXPOSURE PROCESS, LITHOGRAPHY APPARATUS AND COMPUTER PROGRAM**

(71) Applicant: ASML Netherlands B.V., 5500 AH Veldhoven (NL)
(72) Inventor: SCHOONEWELLE, Hielke, 5500 AH Veldhoven (NL); YANG, Yuanqing, 5500 AH Veldhoven (NL); BRINKHOF, Ralph, 5500 AH Veldhoven (NL); DOMEN, Kenian, Franciscus, Elisabeth, Maria, 5500 AH Veldhoven (NL); SHAH, Anuj, Mayur, 5500 AH Veldhoven (NL); PRAMODH, Arjun, 5500 AH Veldhoven (NL); SHRESTHA, Pratik, 5500 AH Veldhoven (NL); YANSON, Oleksiy, Igorevich, 5500 AH Veldhoven (NL); AVEKLOURIS, Angelos, 5500 AH Veldhoven (NL)
(74) Representative: ASML Netherlands B.V.

(57) **Abstract**

Disclosed is a method of determining a correction for an exposure process for exposing structures on a substrate. The method comprises obtaining metrology data relating to at least a first layer on the substrate; modeling the metrology data in accordance with a first field layout of said first layer to obtain at least one first model, the first field layout comprising one or more fields having a first field size; and determining said correction by evaluating said at least one first model in accordance with a second field layout of a second layer on the substrate, said second field layout comprising one or more fields having a second field size different from said first field size.

## Description

### BACKGROUND

### Field of the Invention

The present invention relates to methods of manufacture of devices by lithographic techniques.

### Background Art

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g., including part of, one, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. In lithographic processes, it is desirable frequently to make measurements of the structures created, e.g., for process control and verification. Various tools for making such measurements are known, including scanning electron microscopes, which are often used to measure critical dimension (CD), and specialized tools to measure overlay, a measure of the accuracy of alignment of two layers in a device. Overlay may be described in terms of the degree of misalignment between the two layers, for example reference to a measured overlay of 1nm may describe a situation where two layers are misaligned by 1nm.

Recently, various forms of scatterometers have been developed for use in the lithographic field. These devices direct a beam of radiation onto a target and measure one or more properties of the scattered radiation - e.g., intensity at a single angle of reflection as a function of wavelength; intensity at one or more wavelengths as a function of reflected angle; or polarization as a function of reflected angle - to obtain a "spectrum" from which a property of interest of the target can be determined. Determination of the property of interest may be performed by various techniques: e.g., reconstruction of the target by iterative approaches such as rigorous coupled wave analysis or finite element methods; library searches; and principal component analysis.

The targets used by conventional scatterometers are relatively large, e.g., 40µm by 40µm, gratings and the measurement beam generates a spot that is smaller than the grating (i.e., the grating is underfilled). This simplifies mathematical reconstruction of the target as it can be regarded as infinite. However, in order to reduce the size of the targets, e.g., to 10µm by 10µm or less, e.g., so they can be positioned in amongst product features, rather than in the scribe lane, metrology has been proposed in which the grating is made smaller than the measurement spot (i.e., the grating is overfilled). Typically such targets are measured using dark field scatterometry in which the zeroth order of diffraction (corresponding to a specular reflection) is blocked, and only higher orders processed. Examples of dark field metrology can be found in international patent applications WO 2009/078708 and WO 2009/106279 which documents are hereby incorporated by reference in their entirety. Further developments of the technique have been described in patent publications US20110027704A, US20110043791A and US20120242940A. The contents of all these applications are also incorporated herein by reference. Diffraction-based overlay using dark-field detection of the diffraction orders enables overlay measurements on smaller targets. These targets can be smaller than the illumination spot and may be surrounded by product structures on a wafer. Targets can comprise multiple gratings which can be measured in one image.

Different lithography apparatuses may have different associated field sizes. For example, proposed High-NA (numerical aperture) EUV (extreme ultraviolet) lithography apparatuses may use smaller fields (e.g., half-fields, being half the size of a conventional or typical field size). Other proposed apparatuses may have a larger field size than is typical (e.g., twice the present conventional field size in one or both directions of the substrate plane. These different apparatuses may be used in the manufacture of a single device, i.e., to expose different layers of the device.

It would be desirable to mitigate for the effect of different field sizes of different apparatuses used in the manufacture of a single device.

### SUMMARY

In a first aspect of the invention there is provided a method of determining a correction for an exposure process for exposing structures on a substrate; the method comprising: obtaining metrology data relating to at least a first layer on the substrate; modeling the metrology data in accordance with a first field layout of said first layer to obtain at least one first model, the first field layout comprising one or more fields having a first field size; and determining said correction by evaluating said at least one first model in accordance with a second field layout of a second layer on the substrate, said second field layout comprising one or more fields having a second field size different from said first field size.

In another aspect a computer program comprising processor readable instructions which, when run on suitable processor controlled apparatus, cause the processor controlled apparatus to perform the method of the first aspect and a computer program carrier comprising such a computer program. The processor controlled apparatus may comprise a metrology apparatus or lithographic apparatus or processor therefor.

Further features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

### BRIEF DESCRIPTION OF THE DRAWINGS

Embodiments of the invention will now be described, by way of example only, with reference to the accompanying drawings in which:
Figure 1 depicts a lithographic apparatus according to an embodiment of the invention;
Figure 2 depicts a lithographic cell or cluster according to an embodiment of the invention;

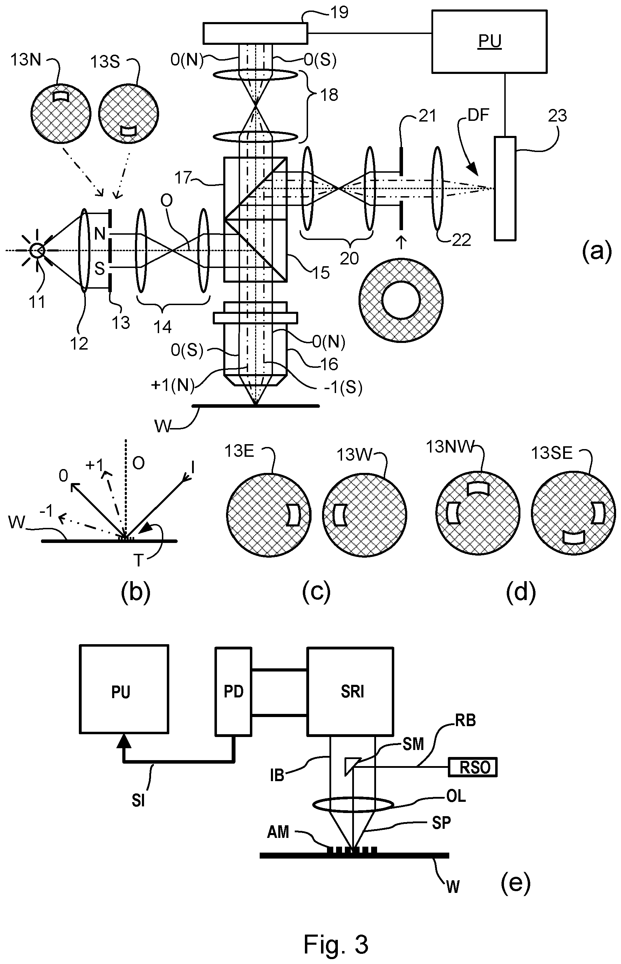

Figure 3(a) comprises a schematic diagram of a dark field scatterometer for use in measuring targets according to embodiments of the invention using a first pair of illumination apertures; Figure 3(b) illustrates a detail of diffraction spectrum of a target grating for a given direction of illumination; Figure 3(c) illustrates a second pair of illumination apertures providing further illumination modes in using the scatterometer for diffraction based overlay measurements; Figure 3(d) illustrates a third pair of illumination apertures combining the first and second pair of apertures; and Figure 3(e) is a schematic block diagram of an embodiment of a known alignment sensor for use in measuring marks according to embodiments of the invention.
Figure 4 is a flow diagram describing an alignment method adaptable using methods disclosed herein;
Figure 5(a) illustrates an alignment method usable for when field sizes differ between layers, according to a first embodiment;
Figure 5(b) illustrates an alignment method usable for when field sizes differ between layers, according to a second embodiment;
Figure 6(a) illustrates an alignment method usable for when field sizes differ between layers, according to a third embodiment;
Figure 6(b) illustrates an alignment method usable for when field sizes differ between layers, according to a fourth embodiment;
Figure 7(a) illustrates an alignment method usable for when field sizes differ between layers, according to a fifth embodiment;
Figure 7(b) illustrates an alignment method usable for when field sizes differ between layers, according to a sixth embodiment;
Figures 8(a), 8(b) and 8(c) illustrate alignment modeling methods for the alignment methods illustrated in Figure 5(a) and 6(a);
Figures 9(a), 9(b) and 9(c) illustrate alignment modeling methods for the alignment methods illustrated in Figure 5(b) and 6(b);
Figures 10(a) and 10(b) illustrate alignment modeling methods for an alignment method according to a seventh embodiment;
Figures 11(a) and 11(b) illustrate alignment modeling methods for an alignment method according to an eighth embodiment; and
Figure 12 is a flow diagram describing an overlay correction method adaptable using methods disclosed herein.

### DETAILED DESCRIPTION OF EXEMPLARY EMBODIMENTS

Before describing embodiments of the invention in detail, it is instructive to present an example environment in which embodiments of the present invention may be implemented.

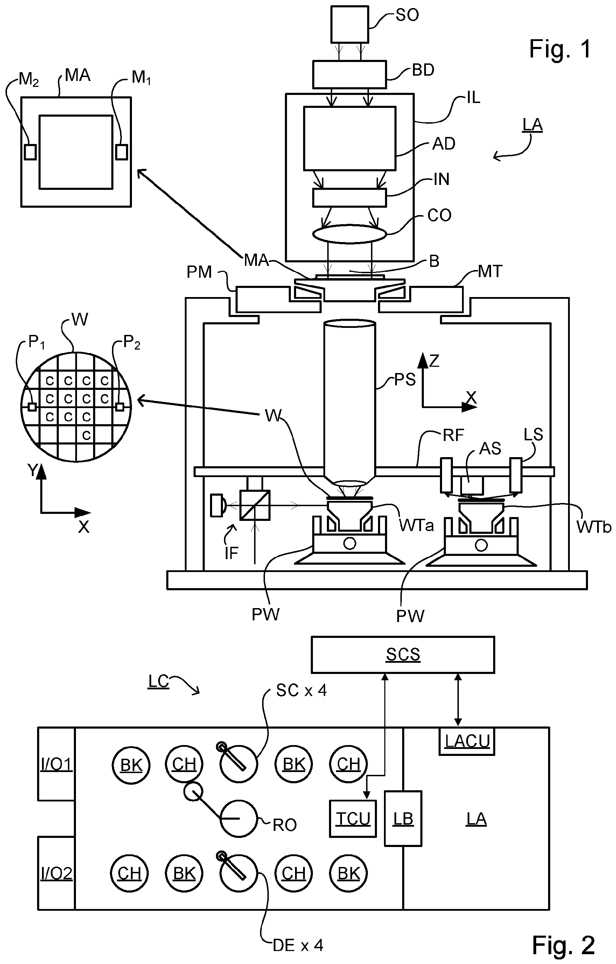

Figure 1 schematically depicts a lithographic apparatus LA. The apparatus includes an illumination optical system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; a substrate table (e.g., a wafer table) WT constructed to hold a substrate (e.g., a resist coated wafer) W and connected to a second positioner PW configured to accurately position the substrate in accordance with certain parameters; and a projection optical system (e.g., a refractive projection lens system) PS configured to project a pattern imparted to the radiation beam B by patterning device MA onto a target portion C (e.g., including one or more dies) of the substrate W.

The illumination optical system may include various types of optical components, such as refractive, reflective, magnetic, electromagnetic, electrostatic or other types of optical components, or any combination thereof, for directing, shaping, or controlling radiation.

The patterning device support holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support may be a frame or a table, for example, which may be fixed or movable as required. The patterning device support may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam, which is reflected by the mirror matrix.

As here depicted, the apparatus is of a transmissive type (e.g., employing a transmissive mask). Alternatively, the apparatus may be of a reflective type (e.g., employing a programmable mirror array of a type as referred to above, or employing a reflective mask).

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems. The term "immersion" as used herein does not mean that a structure, such as a substrate, must be submerged in liquid, but rather only means that liquid is located between the projection system and the substrate during exposure.

Referring to Figure 1, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may include an adjuster AD for adjusting the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may include various other components, such as an integrator IN and a condenser CO. The illuminator may be used to condition the radiation beam, to have a desired uniformity and intensity distribution in its cross section.

The radiation beam B is incident on the patterning device (e.g., mask) MA, which is held on the patterning device support (e.g., mask table MT), and is patterned by the patterning device. Having traversed the patterning device (e.g., mask) MA, the radiation beam B passes through the projection optical system PS, which focuses the beam onto a target portion C of the substrate W, thereby projecting an image of the pattern on the target portion C. With the aid of the second positioner PW and position sensor IF (e.g., an interferometric device, linear encoder, 2-D encoder or capacitive sensor), the substrate table WT can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

Patterning device (e.g., mask) MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment markers may also be included within dies, in amongst the device features, in which case it is desirable that the markers be as small as possible and not require any different imaging or process conditions than adjacent features. The alignment system, which detects the alignment markers is described further below.

Lithographic apparatus LA in this example is of a so-called dual stage type which has two substrate tables WTa, WTb and two stations - an exposure station and a measurement station - between which the substrate tables can be exchanged. While one substrate on one substrate table is being exposed at the exposure station, another substrate can be loaded onto the other substrate table at the measurement station and various preparatory steps carried out. The preparatory steps may include mapping the surface control of the substrate using a level sensor LS and measuring the position of alignment markers on the substrate using an alignment sensor AS. This enables a substantial increase in the throughput of the apparatus.

The depicted apparatus can be used in a variety of modes, including for example a step mode or a scan mode. The construction and operation of lithographic apparatus is well known to those skilled in the art and need not be described further for an understanding of the present invention.

As shown in Figure 2, the lithographic apparatus LA forms part of a lithographic system, referred to as a lithographic cell LC or a lithocell or cluster. The lithographic cell LC may also include apparatus to perform pre- and post-exposure processes on a substrate. Conventionally these include spin coaters SC to deposit resist layers, developers DE to develop exposed resist, chill plates CH and bake plates BK. A substrate handler, or robot, RO picks up substrates from input/output ports I/O1, I/O2, moves them between the different process apparatus and delivers then to the loading bay LB of the lithographic apparatus. These devices, which are often collectively referred to as the track, are under the control of a track control unit TCU which is itself controlled by the supervisory control system SCS, which also controls the lithographic apparatus via lithography control unit LACU. Thus, the different apparatus can be operated to maximize throughput and processing efficiency.

A metrology apparatus suitable for use in embodiments of the invention is shown in Figure 3(a). A target T and diffracted rays of measurement radiation used to illuminate the target are illustrated in more detail in Figure 3(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures, such as those which enable simultaneous illumination and detection from two opposing directions in combination with optical wedges to separate the resultant images. The rest of the pupil plane is desirably dark as any unnecessary light outside the desired illumination mode will interfere with the desired measurement signals.

As shown in Figure 3(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 3(a) and 3(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 3(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled -1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 3 are purely examples. In another embodiment of the invention, on-axis illumination of the targets is used and an aperture stop with an off-axis aperture is used to pass substantially only one first order of diffracted light to the sensor. In yet other embodiments, 2nd, 3rd and higher order beams (not shown in Figure 3) can be used in measurements, instead of or in addition to the first order beams.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 3(c) and (d). The use of these, and numerous other variations and applications of the apparatus are described in prior published applications, mentioned above.

It is known to use an apparatus such as illustrated in Figure 3(a) to measure overlay. To achieve this, overlay targets may be printed on a wafer in two layers. One method of overlay metrology (sometimes referred to as micro-diffraction based overlay (µDBO) infers overlay from an asymmetry imbalance in complementary diffraction orders from targets comprising a respective grating in each layer. Typically, in µDBO the gratings have the same single pitch in each layer, though there may be an imposed bias between the two targets.

In the manufacture of complex devices, typically many lithographic patterning steps are performed, thereby forming functional features in successive layers on the substrate. A critical aspect of performance of the lithographic apparatus is therefore the ability to place the applied pattern correctly and accurately in relation to features laid down in previous layers (by the same apparatus or a different lithographic apparatus). For this purpose, the substrate is provided with one or more sets of marks. Each mark is a structure whose position can be measured at a later time using a position sensor, typically an optical position sensor. The position sensor may be referred to as "alignment sensor" and marks may be referred to as "alignment marks".

A lithographic apparatus may include one or more (e.g. a plurality of) alignment sensors by which positions of alignment marks provided on a substrate can be measured accurately. Alignment (or position) sensors may use optical phenomena such as diffraction and interference to obtain position information from alignment marks formed on the substrate. An example of an alignment sensor used in current lithographic apparatus is based on a self-referencing interferometer as described in US6961116. Various enhancements and modifications of the position sensor have been developed, for example as disclosed in US2015261097A1. The contents of all of these publications are incorporated herein by reference.

A mark, or alignment mark, may comprise a series of bars formed on or in a layer provided on the substrate or formed (directly) in the substrate. The bars may be regularly spaced and act as grating lines so that the mark can be regarded as a diffraction grating with a well-known spatial period (pitch). Depending on the orientation of these grating lines, a mark may be designed to allow measurement of a position along the X axis, or along the Y axis (which is oriented substantially perpendicular to the X axis). A mark comprising bars that are arranged at +45 degrees and/or -45 degrees with respect to both the X- and Y-axes allows for a combined X- and Y- measurement using techniques as described in US2009/195768A, which is incorporated by reference.

The alignment sensor scans each mark optically with a spot of radiation to obtain a periodically varying signal, such as a sine wave. The phase of this signal is analyzed, to determine the position of the mark and, hence, of the substrate relative to the alignment sensor, which, in turn, is fixated relative to a reference frame of a lithographic apparatus. So-called coarse and fine marks may be provided, related to different (coarse and fine) mark dimensions, so that the alignment sensor can distinguish between different cycles of the periodic signal, as well as the exact position (phase) within a cycle. Marks of different pitches may also be used for this purpose.

Measuring the position of the marks may also provide information on a deformation of the substrate on which the marks are provided, for example in the form of a wafer grid. Deformation of the substrate may occur by, for example, electrostatic clamping of the substrate to the substrate table and/or heating of the substrate when the substrate is exposed to radiation.

Figure 3(e) is a schematic block diagram of an embodiment of a known alignment sensor AS, such as is described, for example, in US6961116, and which is incorporated by reference. Radiation source RSO provides a beam RB of radiation of one or more wavelengths, which is diverted by diverting optics onto a mark, such as mark AM located on substrate W, as an illumination spot SP. In this example the diverting optics comprises a spot mirror SM and an objective lens OL. The illumination spot SP, by which the mark AM is illuminated, may be slightly smaller in diameter than the width of the mark itself.

Radiation diffracted by the mark AM is collimated (in this example via the objective lens OL) into an information-carrying beam IB. The term "diffracted" is intended to include zero-order diffraction from the mark (which may be referred to as reflection). A self-referencing interferometer SRI, e.g. of the type disclosed in US6961116 mentioned above, interferes the beam IB with itself after which the beam is received by a photodetector PD. Additional optics (not shown) may be included to provide separate beams in case more than one wavelength is created by the radiation source RSO. The photodetector may be a single element, or it may comprise a number of pixels, if desired. The photodetector may comprise a sensor array.

The diverting optics, which in this example comprises the spot mirror SM, may also serve to block zero order radiation reflected from the mark, so that the information-carrying beam IB comprises only higher order diffracted radiation from the mark AM (this is not essential to the measurement, but improves signal to noise ratios).

Intensity signals SI are supplied to a processing unit PU. By a combination of optical processing in the block SRI and computational processing in the unit PU, values for X- and Y-position on the substrate relative to a reference frame are output.

A single measurement of the type illustrated only fixes the position of the mark within a certain range corresponding to one pitch of the mark. Coarser measurement techniques are used in conjunction with this to identify which period of a sine wave is the one containing the marked position. The same process at coarser and/or finer levels may be repeated at different wavelengths for increased accuracy and/or for robust detection of the mark irrespective of the materials from which the mark is made, and materials on and/or below which the mark is provided. The wavelengths may be multiplexed and de-multiplexed optically so as to be processed simultaneously, and/or they may be multiplexed by time division or frequency division.

In this example, the alignment sensor and spot SP remain stationary, while it is the substrate W that moves. The alignment sensor can thus be mounted rigidly and accurately to a reference frame, while effectively scanning the mark AM in a direction opposite to the direction of movement of substrate W. The substrate W is controlled in this movement by its mounting on a substrate support and a substrate positioning system controlling the movement of the substrate support. A substrate support position sensor (e.g. an interferometer) measures the position of the substrate support (not shown). In an embodiment, one or more (alignment) marks are provided on the substrate support. A measurement of the position of the marks provided on the substrate support allows the position of the substrate support as determined by the position sensor to be calibrated (e.g. relative to a frame to which the alignment system is connected). A measurement of the position of the alignment marks provided on the substrate allows the position of the substrate relative to the substrate support to be determined.

The performance of a lithographic apparatus is conventionally controlled and corrected by methods such as advanced process control (APC) described for example in US2012008127A1, incorporated herein by reference. The advanced process control techniques may use measurements of metrology targets applied to the substrate. A Manufacturing Execution System (MES) may schedule the APC measurements and communicate the measurement results to a data processing unit. The data processing unit may translate the characteristics of the measurement data to a recipe comprising instructions for the lithographic apparatus. This method is very effective in suppressing drift phenomena associated with the lithographic apparatus.

The APC process applies correction in a feedback loop. The APC corrections are set of distortion modeling parameters or correction parameters, sometimes referred to as k-parameters, defined per field of each substrate, i.e. wafer, within a lot. These parameters parameterize the distortion of the imaging across the field of each substrate. For example each correction parameter could describe a certain image distortion component such as one or more of: scaling error, barrel distortion, pincushion distortion, etc. The correction parameters can are also used as input to the lithographic system (scanner) to correct the distortion. Each of these correction parameters may be returned to the scanner by the feedback loop and used to correct the parameters of an associated part of the scanner (e.g. lens, wafer stage, reticle stage) so as to minimize a parameter of interest.

Until recently, all fields on the substrate had the same size in all layers of the stack. Therefore, it was always assumed that the layer being aligned to (the first layer e.g., layer N) has the same field-size as the layer being exposed (the second layer e.g., layer N+1). There was no notion of field size through stack; the same field size was used for alignment modeling to optimize overlay in all layers of the stack.

However, proposed high-NA EUV lithographic apparatuses have a smaller field size than is typical (e.g., half-fields, in that they have half of a typical field size in one direction of the substrate plane and therefore comprise half of a typical field area), while other proposed lithographic apparatuses will have a larger field size than is typical. The different field sizes may be associated with lithography apparatuses with different capabilities (e.g., different resolutions). For example, a common strategy may be to expose one or more critical layers with a (e.g., very) high resolution apparatus (e.g., the aforementioned high-NA EUV) and expose the other layers with a typical (e.g., lower) resolution (e.g., a DUV or lower NA EUV apparatus). This means that the field size will be different through the stack, or at least in one or some layers of the stack. In other words, while the die layout should of course remain the same through the stack, this same die layout may be printed with different field layouts in different layers through the stack.

An issue arises when lithographic apparatuses having different field sizes are used to expose different layers of the same device and intra-field alignment is required. When the field size used for alignment modelling of the intra-field does not match the field size of the first layer (i.e., the already exposed layer being aligned to, which may be the immediately preceding layer (layer N) or other previously exposed layer (layer N-x where x is any integer) depending on alignment strategy), the overlay performance is reduced. This is because the model is fitting an intra-field model which does not match the physical fingerprint on the wafer. In addition, in trying to accommodate such a difference, higher-order intra-field models may be used which may potentially lead to over-fitting and/or extrapolation errors. Alternatively, when the field size used for alignment modeling does not match the field size of the layer being exposed, the applied model does not match the physical fingerprint on the wafer.

In many of the specific examples below, the first layer is represented as layer N; this does not preclude the first layer being any other layer (i.e., layer N-x wherein x is any integer) below the layer being exposed (layer N+1) and, as such, the first layer and second layer as described herein may have other layers between them.

To address this issue, it is proposed to account for the field size of the first layer (the layer being aligned to) when performing wafer alignment modelling and account for the difference in field layout with the second layer (the layer being exposed), when applying the model during exposure. In general, this means that wafer alignment will be flexible and layer-aware, such that its field size is no longer based on the field size of the current layer being exposed but can be extended to any other (previously exposed) layer in the stack. The methods disclosed herein may be referred to as layer-aware metrology. The concepts will be mainly described in terms of alignment, e.g., layer-aware alignment. However, the methods are also applicable to overlay modeling (as will be later described) and therefore layer-aware metrology may also be understood to encompass overlay metrology techniques in addition to alignment metrology.

Layer aware alignment may comprise taking the field size of the first layer into account when modeling the alignment data, rather than using the field size of the second layer for alignment modeling. The first layer being aligned to may be any layer exposed before the second layer (i.e., layer being exposed) on a substrate. For example, the second layer may be overlaid on said first layer.

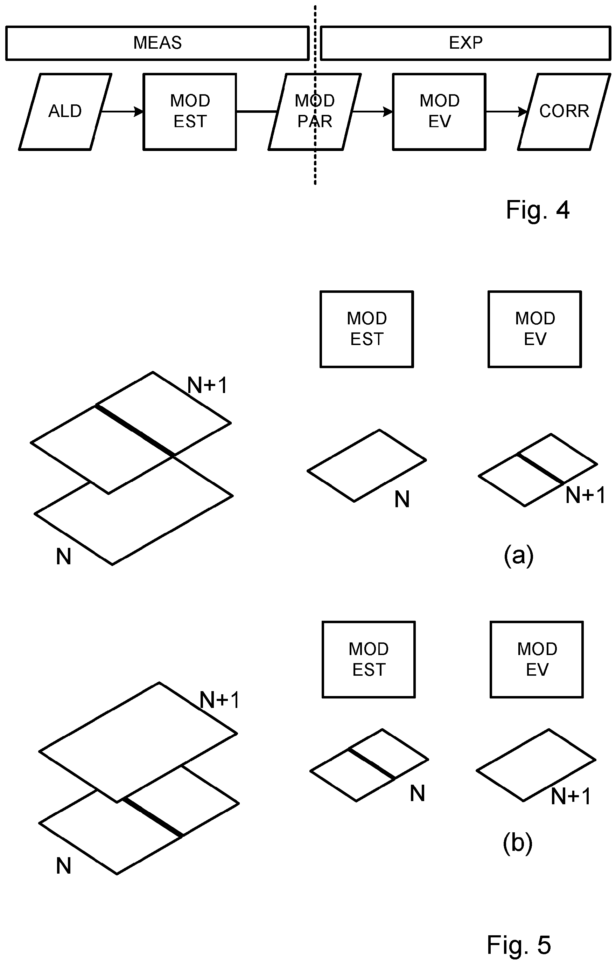

Figure 4 is a flow diagram of a typical alignment process, to which the concepts disclosed herein may be applied. The measurement process MEAS may be performed on a measurement station or "measure side", and the exposure process EXP performed on an exposure station or "expose side", of a dual-stage lithographic apparatus such as illustrated in Figure 1. However, other arrangements are possible, such as performing both alignment metrology and exposure on a single stage lithographic apparatus or performing the alignment metrology on a stand-alone alignment station.

Alignment metrology is performed to obtain alignment data ALD. A model estimation MOD EST is performed to fit an alignment model to the alignment data ALD (e.g., to determine the best model of actual distortion/deformation based on noisy measurements). The resultant model parameters MOD PAR or fitted model is forwarded to the exposure side EXP and a model evaluation MOD EV is performed (e.g., per exposure) on the fitted model to determine positional corrections CORR per exposure. As such, the positional corrections CORR may be determined from modeled positional values as defined by the fitted model.

In typical alignment metrology, the field sizes would not differ between layers, and therefore the model estimation and model evaluation steps are performed on the same exposure field size, where the exposure field size is the field size per single exposure of a particular lithographic apparatus type. Naturally extending such a way of working to a situation where field sizes differ would mean performing the model estimation and model evaluation steps on the second layer field size and field layout. This leads to sub-optimal performance.

Therefore it is proposed to perform the model estimation step MOD EST on the first layer field layout, and the model evaluation step MOD EV on the second layer field layout, wherein the exposure field size is different for the first layer and the second layer. Therefore, the alignment will be flexible and layer-aware, and it will no longer require that field size of first layer and second layer are the same, but able to be extended to any other layer in the stack.

In other words, once the metrology data relating to at least a first layer on the substrate has been obtained, the metrology data is modeled in accordance with a first field layout of said first layer to obtain at least one first model. The first field layout comprising one or more fields having a first field size. Then, a correction is determined by evaluating said at least one first model in accordance with a second field layout of a second layer on the substrate, said second field layout comprising one or more fields having a second field size different from said first field size.

A field in the context of this disclosure may comprise a respective single exposure area as defined by the exposure field size of the lithographic apparatus used to expose that layer. A field layout may describe a layout or arrangement of the fields respectively for the first layer and second layer, e.g., for a common region or area on the substrate comprising one or more dies.

Figure 5 illustrates two particular examples of layer-aware alignment for a first layer N and a second layer N+1 when one of these layers is exposed using a "full-field" field size (a first field size) and the corresponding area of the other of these layers is exposed in two fields of "half-field" field size (a second field size). In Figure 5(a) the full-field size is used in first layer N and the half-field size is used in second layer N+1 (more generally, the first field size is larger than the second field size) and in Figure 5(b) this is reversed (more generally, the first field size is smaller for the second field size). In either case, the model estimation MOD EST is performed on the first layer field layout (i.e., the full-field layout in the Figure 5(a) example and the half-field layout in the Figure 5(b) example). The model evaluation MOD EV is performed on the second layer field layout (i.e., the half-field layout in the Figure 5(a) example and the full-field layout in the Figure 5(b) example). In the Figure 5(b) case, the model fitted to a half-field layout is evaluated twice over the full-field.

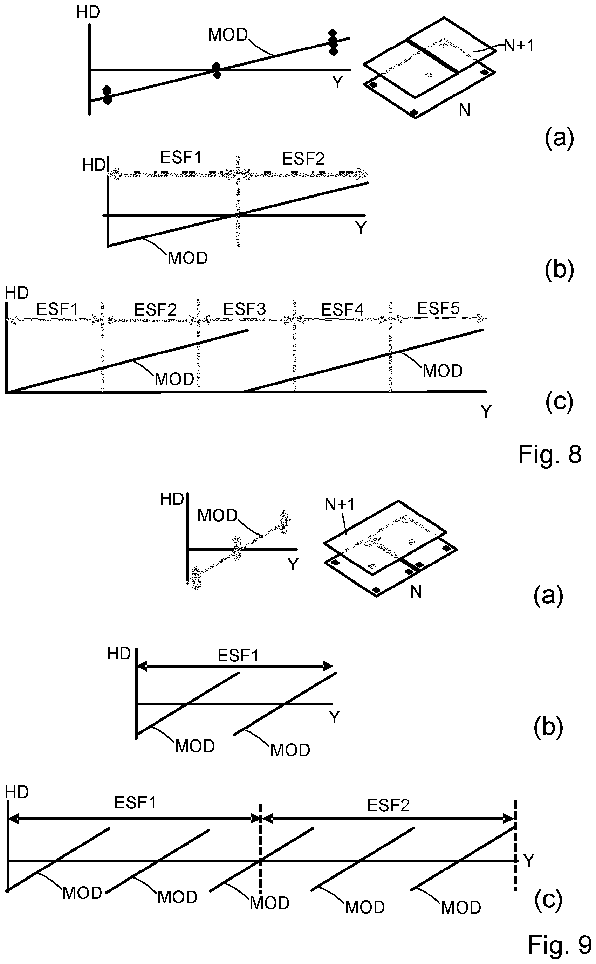

Figures 8 and 9 illustrate the modeling and evaluation steps in a simplified example. Figures 8(a) and 8(b) correspond to the Figure 5(a) example. Figure 8(a) is a simplified representation of the model estimation step or modeling step. The alignment data in the first layer relates to a first layer field layout, here comprising 5 marks per field, based on the full-field size. The plot shows a fitted intra-field model MOD for a single alignment parameter (e.g., MAG Y or Y direction magnification), with horizontal deformation HD on the Y-axis and Y position on the X-axis. Figure 8(b) illustrates the evaluation of the fitted first layer intra-field model MOD over the two exposed fields ESF1, ESF2 of the second layer. This results in respective different correction profiles for each of the two fields being exposed ESF1, ESF2. Figures 9(a) and 9(b) correspond to the Figure 5(b) example. Figure 9(a) is a simplified representation of the model estimation step or modeling step based on a first layer field layout based on the half-field size. Figure 9(b) illustrates the evaluation, twice, of the fitted intra-field model MOD over a layout defined by the larger field ESF1 being exposed in the second layer.

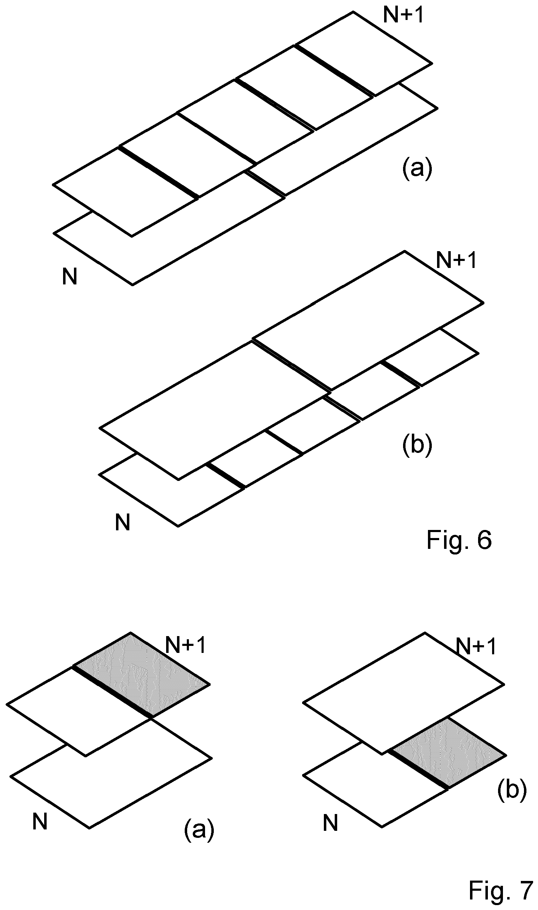

The full-field/half-field examples of Figure 5 are only examples of having different field sizes per layer. Figure 6 illustrates two other proposed examples based on a 5:2 ratio field layout per layer. In such an arrangement, as shown in Figure 6(a), a first layer N field layout comprises two fields exposed using a first lithographic apparatus having a first field size and a second layer field layout comprises five fields exposed using a second lithographic apparatus having a second field size. In the Figure 6(b) example, this is reversed. Referring back to Figure 8, Figure 8(a) is a simplified representation of the model estimation step or modeling step based on a first layer field layout based on the larger field size of the first layer for the Figure 6(a) example. Figure 8(c) illustrates the evaluation, twice, of the fitted intra-field model MOD over the five fields ESF1-ESF5 of the second layer field layout, resulting in different correction profiles for each of the five fields ESF1- ESF5. Similarly, referring back to Figure 9, Figure 9(a) is a simplified representation of the model estimation step or modeling step based on a first layer field layout based on the larger field size of the first layer for the Figure 6(b) example. Figure 9(c) illustrates the evaluation, 2.5 times, of the fitted intra-field model MOD over a respective layout defined by each of the two fields ESF1, ESF2 of the second layer field layout.

Note that the number and sizes of the fields in the second layer and the first layer may differ from those described and shown in the examples and the concepts herein are applicable to any arrangement where field sizes differ between layers (e.g., where a first field layout of the first layer is defined by L fields and a second field layout of the second layer is defined by M fields, L and M being different and each being any number, such that the field sizes are different in the two layers). Other examples include 1:3 ratio (full-field to third-field) and *vice versa*, 7:2 ratio and *vice versa etc..*

It can be appreciated that more than one model may be fitted to the first layer (the layer being aligned to). For example, in embodiments where there are two or more fields in the first layer, at least one of those fields may be allowed to differ from the other(s) (i.e., result from an exposure from a different respective reticle; e.g., such that at least one first field is exposed from at least a first reticle and at least one second field is exposed from at least a second reticle). In such an embodiment, each of the first layer fields may be individually modeled, with each model used to evaluate a corresponding respective region of the second layer.

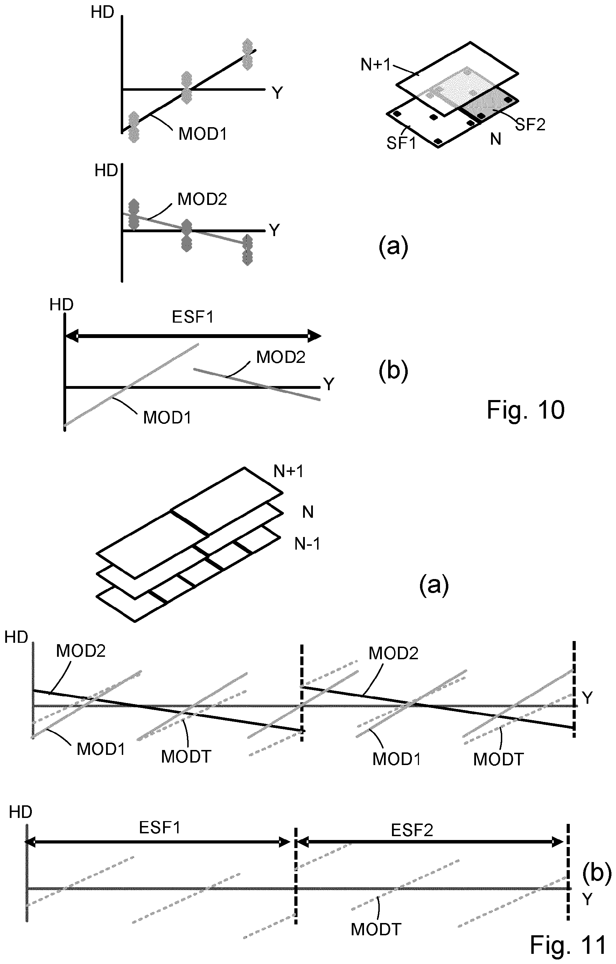

Figure 10 illustrates such an embodiment. Figure 10(a) illustrates that the first layer N comprises a field layout of two different fields SF1, SF2, each of which having its own respective alignment data to which a respective model MOD1, MOD2 is fitted, and to which a second layer N+1 is being aligned. Assuming that the second layer N+1 field layout comprises a single exposed field ESF1 (i.e., a single full-field being aligned to two different half-fields), then both models MOD1, MOD2 may be evaluated on the exposure field ESF1, as shown in Figure 10(b).

Figure 11 illustrates another embodiment of intra-field alignment requiring two intra-field models. In such an embodiment, as illustrated in Figure 11(a) there is field deformation resulting from two (or more) previous first layers. When intra-field alignment of layer N is performed to layer N-1, the field deformation of layer N-1 will also be present in layer N. For the exposure of layer N+1, alignment marks printed in layer N are measured and modelled using a combined model of the inter-field model and the two intra-field models MOD1 and MOD2. The total deformation MODT can then be determined as a combination of first model MOD1 and second model MOD2. Figure 11(b) shows the combination of both intra-field models MODT being evaluated over the second layer N+1 field layout ESF1, ESF2.

The field layout arrangement shown in Figure 11(a) may alternatively represent a split-alignment case where one substrate plane direction is aligned to layer N-1 and the other direction substrate plane direction is aligned to layer N. When evaluating the layer N model on layer N+1, the field-size difference should be considered as has been described herein.

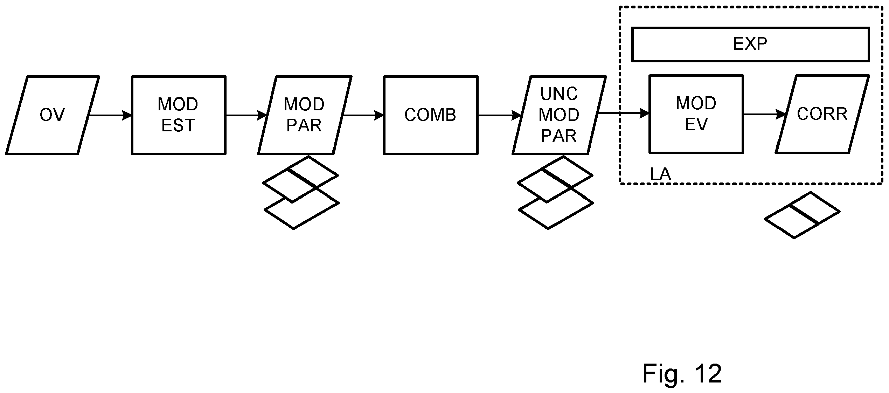

As previously mentioned, the method disclosed can also be applied to overlay metrology. Figure 12 illustrates overlay metrology method according to such an embodiment. Overlay metrology data OV (e.g., as measured using a scatterometer) may have one or more intra-field models fitted MOD EST to each of the first layer (bottom layer) and second layer (top layer), so as to define a set of model parameters for each layer. The model estimation may comprise determining or fitting a respective intra-field model (e.g., averaged over the fields on the substrate) for each of the first layer (bottom layer) and second layer (top layer). Other models may also be fitted, e.g., an inter-field model). The result of this step is separate intra-field models for the induced field deformation caused by exposure of the first layer and the induced field deformation caused by exposure of the second layer. Optionally, each of these models may be further determined per scan direction. A combination step COMB may combine the model parameters of different substrates and/or lots. The unconstrained model parameters UNC MOD PAR are used by the lithographic apparatus LA in an exposure step EXP to evaluate both the first layer and second layer models MOD EV. Note that this is in contrast to other methods where the combination step comprises a conversion to constrained correction parameters per field of the second layer, which are forwarded to the lithographic apparatus, such that the constrained second layer model (only) is evaluated on the exposure grid. Instead, here the model evaluation step MOD EV comprises evaluating both the first layer model and second layer model on the second layer field layout to determine positional corrections CORR for subsequent exposures. As such, in the proposed method, models of both layers are evaluated, rather than an evaluation of only the second layer.

The specific examples given are only a few examples for which the methods disclosed herein are applicable. The concepts herein may be generally applicable to arrangements where field sizes differ per exposure in different layers; e.g., where two or more different lithographic apparatuses are used to expose a substrate, each having an associated different exposure field size.

With layer-awareness as disclosed herein, a perfect fit can be achieved such that the overlay residuals are zero; e.g., when the number of fields is greater in the second layer than in the first layer such as illustrated in Figure 5(a). Even when the number of fields is fewer in the second layer than in the first layer such as illustrated in Figure 5(b), overlay performance will be improved with respect to a no layer-awareness example. The fitted model will be aware that the alignment marks printed on the first layer were printed according to settings different to the second layer settings. Thus, for the second layer, the alignment data measured on the first layer layout will be modeled using a model which optimizes the first layer conditions (field size) and not the second layer conditions. Once the physical field deformation is calculated/estimated based on the modeled alignment data, a correction can be determined in terms of the second layer conditions.

While the targets described above are metrology targets specifically designed and formed for the purposes of measurement, in other embodiments, properties may be measured on targets which are functional parts of devices formed on the substrate. Many devices have regular, grating-like structures. The terms 'target grating' and 'target' as used herein do not require that the structure has been provided specifically for the measurement being performed. Further, pitch P of the metrology targets is close to the resolution limit of the optical system of the scatterometer, but may be much larger than the dimension of typical product features made by lithographic process in the target portions C. In practice the lines and/or spaces of the overlay gratings within the targets may be made to include smaller structures similar in dimension to the product features.

In association with the physical grating structures of the targets as realized on substrates and patterning devices, an embodiment may include a computer program containing one or more sequences of machine-readable instructions describing methods of measuring targets on a substrate and/or analyzing measurements to obtain information about a lithographic process. This computer program may be executed for example within unit PU in the apparatus of Figure 3 and/or the control unit LACU of Figure 2. There may also be provided a data storage medium (e.g., semiconductor memory, magnetic or optical disk) having such a computer program stored therein. Where an existing metrology apparatus, for example of the type shown in Figure 3, is already in production and/or in use, the invention can be implemented by the provision of updated computer program products for causing a processor to perform the methods disclosed herein.

While the embodiments disclosed above are described in terms of diffraction based overlay measurements (e.g., measurements made using the second measurement branch of the apparatus shown in Figure 3(a)), in principle the same models can be used for pupil based overlay measurements (e.g., measurements made using the first measurement branch of the apparatus shown in Figure 3(a)). Consequently, it should be appreciated that the concepts described herein are equally applicable to diffraction based overlay measurements and pupil based overlay measurements.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The following numbered clauses define other aspects and/or features of the concepts disclosed herein:
1. A method of determining a correction for an exposure process for exposing structures on a substrate; the method comprising:
   obtaining metrology data relating to at least a first layer on the substrate;
   modeling the metrology data in accordance with a first field layout of said first layer to obtain at least one first model, the first field layout comprising one or more fields having a first field size; and
   determining said correction by evaluating said at least one first model in accordance with a second field layout of a second layer on the substrate, said second field layout comprising one or more fields having a second field size different from said first field size.
2. A method according to clause 1, wherein said first field size is determined by an exposure field area of a first lithographic apparatus used to expose said first layer, and said second field size is determined by an exposure field area of a second lithographic apparatus used to expose said second layer.
3. A method according to clause 1 or 2, wherein said metrology data comprises alignment data and said correction comprises a positional correction for exposure of said second layer.
4. A method according to clause 1 or 2, wherein said metrology data comprises overlay data;
   wherein said modeling the metrology data in accordance with a first field layout comprises determining said at least one first model relating to said first layer and at least one second model relating to said second layer; and
   wherein said determining a correction comprises determining a correction by evaluating said at least one first model and said at least one second model in accordance with the second field layout.
5. A method according to any preceding clause, wherein said first field layout and said second field layout each cover the same area of the substrate, divided into a respective different number of fields per field layout.
6. A method according to any preceding clause, wherein each said model comprises an intra-field model.
7. A method according to any preceding clause, wherein said first field layout comprises two fields and said second field layout comprises one field.
8. A method according to any of clauses 1 to 6, wherein said second field layout comprises two fields and said first field layout comprises one field.
9. A method according to any preceding clause, wherein said first field layout comprises at least one first field exposed using a first reticle and at least one second field exposed using a second reticle, different to said first reticle;
   wherein said modeling step comprises fitting a first model to said metrology data relating to said at least one first field and a second model to said metrology data relating to said at least one second field; and
   wherein said determining said correction step comprises evaluating said first model and said second model in accordance with said second field layout.
10. A method according to any of clauses 1 to 8, wherein said metrology data relates to two first layers, each comprising a respective different field layout,
   wherein said modeling the metrology data in accordance with a first field layout comprises determining said at least one first model relating to a first of said respective different field layouts and at least one second model relating to a second of said respective different field layouts; and
   wherein said determining a correction comprises determining a correction by evaluating said at least one first model and said at least one second model in accordance with the second field layout.
11. A method according to clause 10, wherein said second field layout is the same as one of said respective different field layouts.
12. A method according to any preceding clause, comprising performing an exposure of said second layer in accordance with said correction.
13. A method according to clause in any preceding clause, wherein said second layer overlays said first layer.
14. A method according to clause 13, wherein said second layer directly overlays said first layer.
15. A method according to clause 13, wherein there is one or more intervening layers between said first layer and second layer.
16. A method according to clause in any preceding clause, wherein said first field size is larger than said second field size.
17. A method according to clause in any of clauses 1 to 15, wherein said first field size is smaller than said second field size.
18. A computer program comprising program instructions operable to perform the method of any preceding clause, when run on a suitable apparatus.
19. A non-transient computer program carrier comprising the computer program of clause 18.
20. A processing arrangement comprising:
   a non-transient computer program carrier comprising a computer program comprising program instructions operable to perform the method of any of clauses 1 to 12, when run on a suitable apparatus; and
   a processor operable to run the computer program comprised on said non-transient computer program carrier.
21. One or more lithographic apparatuses, each said one or more lithographic apparatuses comprising:
   a patterning device support for supporting a patterning device;
   a substrate support for supporting the substrate; and
   a projection system operable to perform at least one of said first exposure and said second exposure;
   wherein said one or more lithographic apparatuses comprise the processing arrangement of clause 20.
22. An integrated circuit manufactured using the method of any of clauses 1 to 17.

The breadth and scope of the present invention should not be limited by any of the above-described exemplary embodiments, but should be defined only in accordance with the following claims and their equivalents.

## Claims

1. A method of determining a correction for an exposure process for exposing structures on a substrate; the method comprising:
obtaining metrology data relating to at least a first layer on the substrate;
modeling the metrology data in accordance with a first field layout of said first layer to obtain at least one first model, the first field layout comprising one or more fields having a first field size; and
determining said correction by evaluating said at least one first model in accordance with a second field layout of a second layer on the substrate, said second field layout comprising one or more fields having a second field size different from said first field size.

2. A method as claimed in claim 1, wherein said first field size is determined by an exposure field area of a first lithographic apparatus used to expose said first layer, and said second field size is determined by an exposure field area of a second lithographic apparatus used to expose said second layer.

3. A method as claimed in claim 1 or 2, wherein said metrology data comprises alignment data and said correction comprises a positional correction for exposure of said second layer.

4. A method as claimed in claim 1 or 2, wherein said metrology data comprises overlay data;
wherein said modeling the metrology data in accordance with a first field layout comprises determining said at least one first model relating to said first layer and at least one second model relating to said second layer; and
wherein said determining a correction comprises determining a correction by evaluating said at least one first model and said at least one second model in accordance with the second field layout.

5. A method as claimed in any preceding claim, wherein said first field layout and said second field layout each cover the same area of the substrate, divided into a respective different number of fields per field layout.

6. A method as claimed in any preceding claim, wherein each said model comprises an intra-field model.

7. A method as claimed in any preceding claim, wherein said first field layout comprises two fields and said second field layout comprises one field.

8. A method as claimed in any of claims 1 to 6, wherein said second field layout comprises two fields and said first field layout comprises one field.

9. A method as claimed in any preceding claim, wherein said first field layout comprises at least one first field exposed using a first reticle and at least one second field exposed using a second reticle, different to said first reticle;
wherein said modeling step comprises fitting a first model to said metrology data relating to said at least one first field and a second model to said metrology data relating to said at least one second field; and
wherein said determining said correction step comprises evaluating said first model and said second model in accordance with said second field layout.

10. A method as claimed in any of claims 1 to 8, wherein said metrology data relates to two first layers, each comprising a respective different field layout,
wherein said modeling the metrology data in accordance with a first field layout comprises determining said at least one first model relating to a first of said respective different field layouts and at least one second model relating to a second of said respective different field layouts; and
wherein said determining a correction comprises determining a correction by evaluating said at least one first model and said at least one second model in accordance with the second field layout.

11. A method as claimed in claim 10, wherein said second field layout is the same as one of said respective different field layouts.

12. A method as claimed in any preceding claim, comprising performing an exposure of said second layer in accordance with said correction.

13. A computer program comprising program instructions operable to perform the method of any preceding clause, when run on a suitable apparatus.

14. A processing arrangement comprising:
a non-transient computer program carrier comprising a computer program comprising program instructions operable to perform the method of any of claims 1 to 12, when run on a suitable apparatus; and
a processor operable to run the computer program comprised on said non-transient computer program carrier.

15. One or more lithographic apparatuses, each said one or more lithographic apparatuses comprising:
a patterning device support for supporting a patterning device;
a substrate support for supporting the substrate; and
a projection system operable to perform at least one of said first exposure and said second exposure;
wherein said one or more lithographic apparatuses comprise the processing arrangement of claim 14.
